(19) Europäisches Patentamt / European Patent Office / Office européen des brevets

(11) **EP 3 742 594 A1**

(12) **EUROPEAN PATENT APPLICATION**

(43) Date of publication:
**25.11.2020 Bulletin 2020/48**

(51) Int Cl.:
**H02M 1/32** (2007.01) **H03K 17/082** (2006.01)

(21) Application number: **20161882.4**

(22) Date of filing: **09.03.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.05.2019 JP 2019096185**

(71) Applicants:
• **Kabushiki Kaisha Toshiba**
**Minato-ku**
**Tokyo (JP)**

• **Toshiba Energy Systems & Solutions Corporation**
**Saiwai-ku**
**Kawasaki-shi**
**Kanagawa (JP)**

(72) Inventor: **IKEDA, Kentaro**
**Tokyo (JP)**

(74) Representative: **Moreland, David**
**Marks & Clerk LLP**
**Aurora**
**120 Bothwell Street**
**Glasgow G2 7JS (GB)**

(54) **PEAK HOLD CIRCUIT AND POWER CONVERTER**

(57) A peak hold circuit has a first capacitor (C1) and a second capacitor (C2) that are serially connected between a voltage input node and a reference voltage node, a first rectifying element (D1) that has an anode connected to the reference voltage node and a cathode connected to a connection node of the first capacitor (C1) and the second capacitor (C2), a second rectifying element (D2) that has an anode connected to the connection node of the first capacitor (C1) and the second capacitor (C2), and a cathode, and a third capacitor (C3) that is connected between the cathode of the second rectifying element (D2) and the reference voltage node, wherein a peak value of a surge voltage input to the voltage input node is output from the cathode of the second rectifying element (D2).

1 : PEAK HOLD CIRCUIT

FIG. 1

Printed by Jouve, 75001 PARIS (FR)

**Description**

FIELD

Examples of the present invention relate to a peak hold circuit and a power converter.

BACKGROUND

A power converter that converts a DC voltage into an AC voltage generates an AC voltage by turning on and off a power transistor at a predetermined period. As an in-vehicle motor or the like requires a large drive voltage, the amplitude of the AC voltage generated by the power converter must be increased accordingly. When a motor load varies greatly or some abnormality occurs, a large surge voltage is generated in the AC voltage generated by the power converter, which may cause damage to devices and EMI noise.

If it is possible to accurately detect how much surge voltage has generated in an output voltage of the power converter or the like, it is preferable because failure diagnosis can be performed and measures to reduce the surge voltage can be taken.

BRIEF DESCRIPTION OF THE DRAWINGS

FIG. 1 is a circuit diagram of a peak hold circuit according to a first example;
FIG. 2A is a diagram for explaining a circuit operation of the peak hold circuit of FIG. 1;
FIG. 2B is a diagram for explaining the circuit operation of the peak hold circuit of FIG. 1;
FIG. 2C is a diagram for explaining the circuit operation of the peak hold circuit of FIG. 1;
FIG. 3 is a diagram illustrating a voltage waveform of a voltage input node and a voltage waveform of a voltage output node;
FIG. 4 is a diagram illustrating the voltage waveforms of the voltage input node and the voltage output node in a time period longer than that of FIG. 3;
FIG. 5 illustrates voltage waveform diagrams of the voltage input node and the voltage output node based on experimental results;
FIG. 6 is an enlarged diagram of the voltage waveforms of the voltage input node and the voltage output node illustrated in FIG. 5;
FIG. 7 is a circuit diagram of a peak hold circuit according to a comparative example;
FIG. 8 illustrates voltage waveform diagrams of a voltage input node and a voltage output node in the peak hold circuit of FIG. 7;
FIG. 9 is an enlarged diagram of a part of the voltage waveforms illustrated in FIG. 7;
FIG. 10A is a circuit diagram illustrating a first example of compensating for a voltage drop corresponding to a forward voltage of a first rectifying element;
FIG. 10B is a circuit diagram illustrating a second example of compensating for the voltage drop corresponding to the forward voltage of the first rectifying element;
FIG. 10C is a circuit diagram illustrating a third example of compensating for the voltage drop corresponding to the forward voltage of the first rectifying element;
FIG. 11 is a circuit diagram of a peak hold circuit according to a third example;
FIG. 12 is a circuit diagram of a peak hold circuit according to a fourth example;
FIG. 13 illustrates voltage waveform diagrams of a voltage input node and a voltage output node in the peak hold circuit of FIG. 12;
FIG. 14 is a circuit diagram of a first example of a power converter; and
FIG. 15 is a circuit diagram of a second example of the power converter.

DETAILED DESCRIPTION

According to one example, a peak hold circuit has a first capacitor and a second capacitor that are serially connected between a voltage input node and a reference voltage node, a first rectifying element that has an anode connected to the reference voltage node and a cathode connected to a connection node of the first capacitor and the second capacitor, a second rectifying element that has an anode connected to the connection node of the first capacitor and the second capacitor, and a cathode, and a third capacitor that is connected between the cathode of the second rectifying element and the reference voltage node, wherein a peak value of a surge voltage input to the voltage input node is output from the cathode of the second rectifying element.

Hereinafter, examples of a peak hold circuit and a power converter will be described with reference to the drawings. The main components of the peak hold circuit and the power converter will be mainly described below. However, the peak hold circuit and the power converter may have components and functions that are not illustrated or described. The following description does not exclude the components and functions that are not illustrated or described.

(First Example)

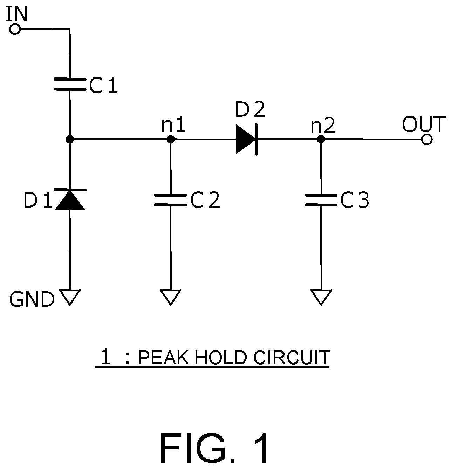

FIG. 1 is a circuit diagram of a peak hold circuit 1 according to a first example. The peak hold circuit 1 of FIG. 1 includes a first capacitor C1, a second capacitor C2, a first rectifying element D1, a second rectifying element D2, and a third capacitor C3.

The first capacitor C1 and the second capacitor C2 are connected between a voltage input node IN and a reference voltage node GND. A voltage that may include a surge voltage such as an output voltage of a power converter (not illustrated in FIG. 1) is input to the voltage input node IN. The peak hold circuit 1 according to the present example is characterized by accurately detecting a surge voltage included in a voltage input to the voltage input node IN, regardless of the type of a device or a circuit connected to the voltage input node IN. The reference voltage node GND is, for example, a ground node, but a specific voltage level is not limited.

The first rectifying element D1 can be configured by a diode having an anode connected to the reference voltage node GND and a cathode connected to a connection node n1 of the first capacitor C1 and the second capacitor C2.

The second rectifying element D2 can be configured by a diode having an anode connected to the connection node n1 of the first capacitor C1 and the second capacitor C2. A peak value of a surge voltage input to the voltage input node IN is output from a cathode of the second rectifying element D2.

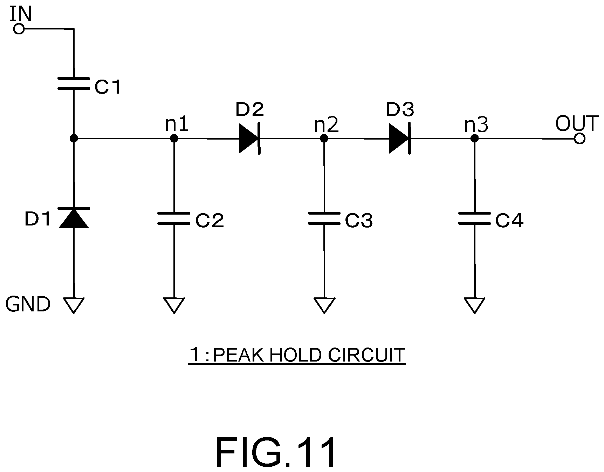

In the peak hold circuit 1 of FIG. 1, the third capacitor C3 is connected between the cathode of the second rectifying element D2 and the reference voltage node GND, and a voltage output node OUT is connected to a connection node n2 of the cathode of the second rectifying element D2 and the third capacitor C3. Consequently, the peak value of the voltage input to the voltage input node IN is output from the voltage output node OUT. As illustrated in FIG. 11 to be described later, it is not always necessary to connect the voltage output node OUT to the cathode of the second rectifying element D2.

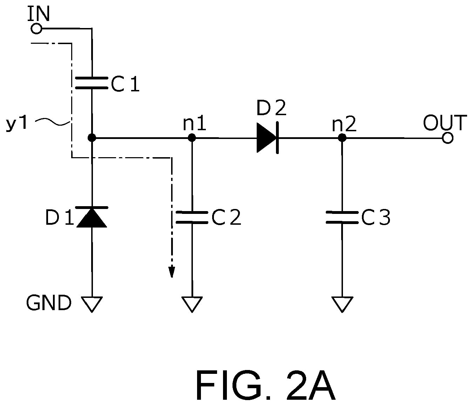

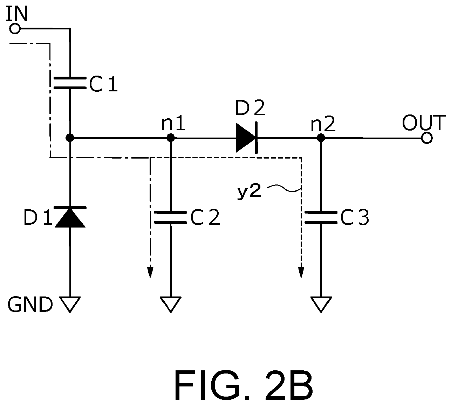

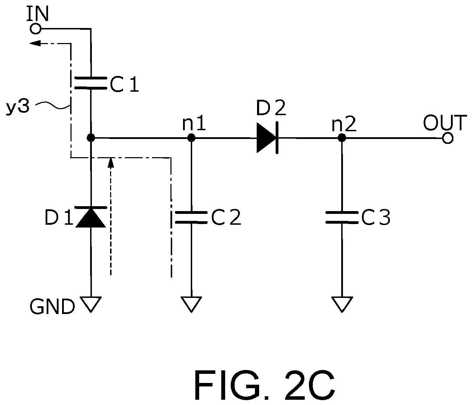

FIG. 2A, FIG. 2B and FIG. 2C are diagrams for explaining a circuit operation of the peak hold circuit 1 of FIG. 1. When the voltage input to the voltage input node IN increases, a current flows from the voltage input node IN through the first capacitor C1 to the second capacitor C2, as indicated by an arrow line y1 in FIG. 2A. The voltage of the voltage input node IN is thus divided by the first capacitor C1 and the second capacitor C2.

As the amount of electric charge stored in the second capacitor C2 increases, a voltage VC2 of the connection node n1 of the first capacitor C1 and the second capacitor C2 gradually increases. As indicated by expression (1), when the voltage VC2 of the connection node n1 is higher than a voltage obtained by adding a forward voltage VfD2 of the second rectifying element D2 to a voltage VC3 of the connection node n2 of the cathode of the second rectifying element D2 and the third capacitor C3, a current starts to flow from the second capacitor C2 through the second rectifying element D2 to the third capacitor C3, as indicated by an arrow line y2 in FIG. 2B.

$$VC2 > VC3 + VfD2 \quad …(1)$$

Thereafter, when the voltage of the voltage input node IN decreases, as indicated by an arrow line y3 in FIG. 2C, a current flows from the second capacitor C2 through the first capacitor C1 to the voltage input node IN, and the electric charge stored in the first capacitor C1 is discharged. At this time, the second rectifying element D2 prevents the current from the third capacitor C3 from flowing into the first capacitor C1, so that the electric charge stored in the third capacitor C3 is held. As a result, the peak value of the surge voltage of the voltage input node IN is held by the third capacitor C3, and the peak value of the surge voltage is continuously output from the voltage output node OUT connected to the third capacitor C3.

A voltage Vdetect of the voltage output node OUT in the peak hold circuit 1 of FIG. 1 is indicated by the following expression (2).

$$V_{detect} \fallingdotseq \frac{C_1}{C_1 + C_2 + C_3} V_p - Vf_{D1} - Vf_{D2} \quad …(2)$$

When the capacitance of the third capacitor C3 is much smaller than the capacitance of the second capacitor C2, expression (2) can be approximated as expression (3).

$$V_{detect} \fallingdotseq \frac{C_1}{C_1 + C_2} V_p - Vf_{D1} - Vf_{D2} \quad \cdots (3)$$

As indicated by expression (3), the voltage of the voltage output node OUT is determined by a capacitance partial voltage ratio of the first capacitor C1 and the second capacitor C2, where a forward voltage VfD1 of the first rectifying element D1 and the forward voltage VfD2 of the second rectifying element D2 are ignored. As a high voltage of about several hundred kV to several kV may be applied to the voltage input node IN in the peak hold circuit 1 of the present example, the capacitance C2 of the second capacitor C2 is preferably larger than the capacitance C1 of the first capacitor C1. Consequently, even when a high voltage is input to the voltage input node IN, a voltage obtained by reducing the high voltage using the capacitance partial voltage ratio of the first capacitor C1 and the second capacitor C2 can be output from the voltage output node OUT.

The voltage input to the voltage input node IN may vary due to ringing, and thus it is preferable that the voltage output from the voltage output node OUT is not affected by the ringing.

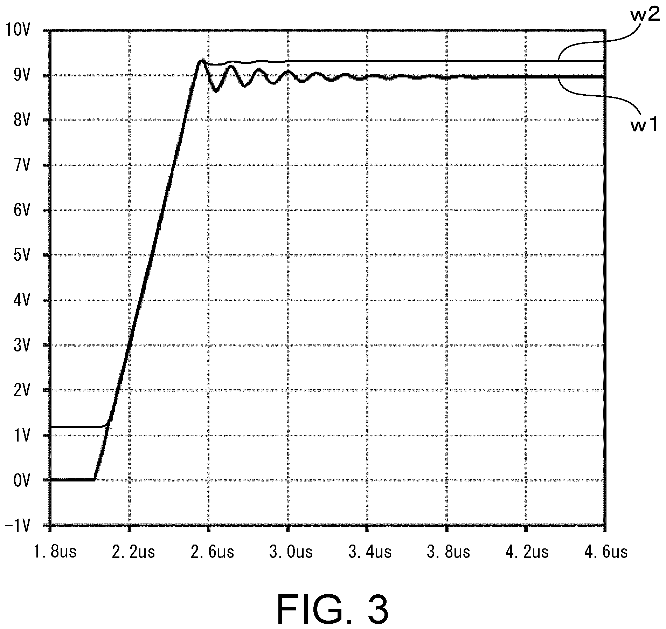

FIG. 3 is a diagram illustrating a voltage waveform w1 of the voltage input node IN and a voltage waveform w2 of the voltage output node OUT. In FIG. 3, a horizontal axis represents a time [$\mu$s] and a vertical axis represents a voltage level [V]. The voltage waveform w1 in FIG. 3 illustrates an example in which the voltage input to the voltage input node IN varies due to ringing.

In order to avoid the influence of ringing, the capacitance of the second capacitor C2 has to be larger than the capacitance of the third capacitor C3. If the capacitance of the third capacitor C3 is larger than the capacitance of the second capacitor C2, and the amount of electric charge stored in the second capacitor C2 is full, the current having flown from the voltage input node IN through the first capacitor C1 flows through the second rectifying element D2 to the third capacitor C3, and thus the voltage of the voltage output node OUT increases. At this time, if ringing occurs in the voltage of the voltage input node IN, the voltage of the voltage output node OUT increases due to the ringing. For this reason, it is preferable that the capacitance of the second capacitor C2 is larger than the capacitance of the third capacitor C3 so that no electric charge is stored in the third capacitor C3 when the voltage of the voltage input node IN varies due to ringing.

In order to avoid the influence of ringing, it is necessary to satisfy the following expression (4).

$$\frac{C_1 V_{in0}}{C_1 + C_2 + C_3} + Vf_D \geq \frac{C_1 V_{in1}}{C_1 + C_2} \quad \cdots (4)$$

In a case where the voltage input to the voltage input node IN changes periodically and the voltage of the voltage input node IN in a first cycle is denoted by VinO, the voltage of the connection node n1 of the second capacitor C2 and the second rectifying element D2 when a current flows from the second capacitor C2 through the second rectifying element D2 to the third capacitor C3 has a value obtained by adding the forward voltage VfD of the second rectifying element D2 to the voltage across the second capacitor C2, which is represented by the left hand side of expression (4).

Assuming that a voltage Vinl of the voltage input node IN in a second cycle following the first cycle includes ringing, the voltage of the connection node n1 in the second cycle is expressed by the right hand side of expression (4). Consequently, to prevent the current due to a ringing component from flowing to the third capacitor C3, the voltage across the second capacitor C2 in the second cycle is required to be less than the voltage across the third capacitor C3 in the first cycle. The relationship of expression (4) is thus obtained.

When expression (4) is transformed, expression (5) or expression (6) is obtained.

$$C_2 \geq \frac{\sqrt{4C_1 \cdot C_3.Vf \cdot V_{in} + C_3{}^2 Vf^2} + (-C_3 - 2C_1)Vf}{2Vf} \quad \cdots (5)$$

$$C_3 \leq \frac{(C_2{}^2 + 2C_1 C_2 + C_1{}^2)Vf}{C_1 V_{in} + (-C_2 - C_1)Vf} \quad \cdots (6)$$

When capacitance values of the first capacitor C1 and the second capacitor C2 are set first, a capacitance value of the third capacitor C3 may be set so as to satisfy inequality (6). Further, when the capacitance values of the first capacitor C1 and the third capacitor C3 are set first, the capacitance value of the second capacitor C2 may be set so as to satisfy inequality (5). Expression (5) and expression (6) are obtained by transforming expression (4) and the capacitances of the first to third capacitors C1 to C3 are set so as to satisfy expression (4). Consequently, even when the voltage of the voltage input node IN varies due to ringing, the voltage of the voltage output node OUT is hardly affected by ringing, as in the voltage waveform w2 in FIG. 3, for example.

The voltage waveforms w1 and w2 in FIG. 3 are actually greatly different in voltage level, and the voltage level of the voltage waveform w1 of the voltage input node n1 is larger than the voltage level of the voltage waveform w2 of the voltage output node n2. In FIG. 3, the voltage level of the voltage waveform w1 is scaled and displayed in order to make it easier to compare the influence of ringing.

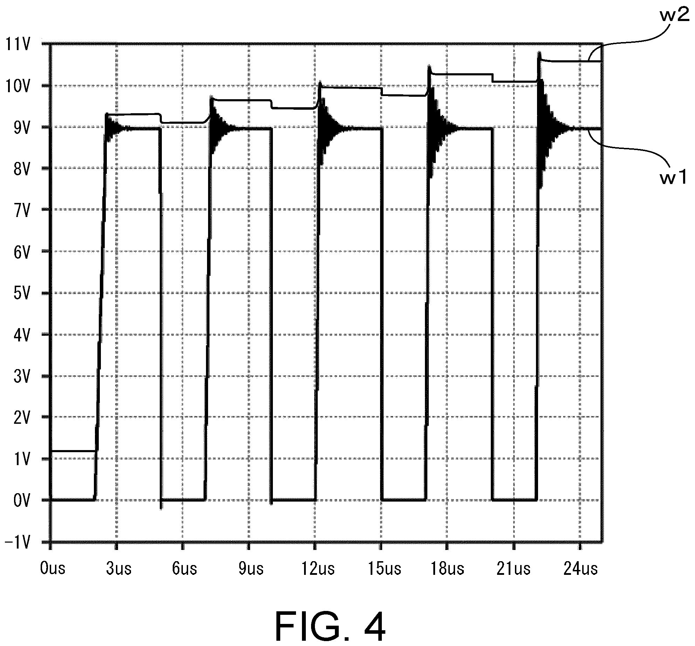

FIG. 4 is a diagram illustrating the voltage waveform w1 of the voltage input node IN and the voltage waveform w2 of the voltage output node OUT in a time period longer than that of FIG. 3. The voltage level of the voltage waveform w1 in FIG. 4 is also scaled and displayed. The waveform diagram of FIG. 4 illustrates a result of a simulation.

In the example of FIG. 4, the voltage of the voltage input node IN is an AC voltage that changes periodically. As can be seen from the voltage waveform w1 of FIG. 4, a surge voltage is generated at the rise of each cycle. The peak hold circuit 1 of FIG. 1 holds a peak value of the surge voltage as illustrated in FIG. 4.

In FIG. 4, the voltage of the voltage output node OUT slightly decreases from a holding voltage at a timing when the voltage input to the voltage input node IN falls. This is due to the parasitic capacitance of the second rectifying element D2. It is essentially preferable to continuously maintain the holding voltage regardless of a change in the voltage of the voltage input node IN. Measures for periodic decrease in the holding voltage will be described later.

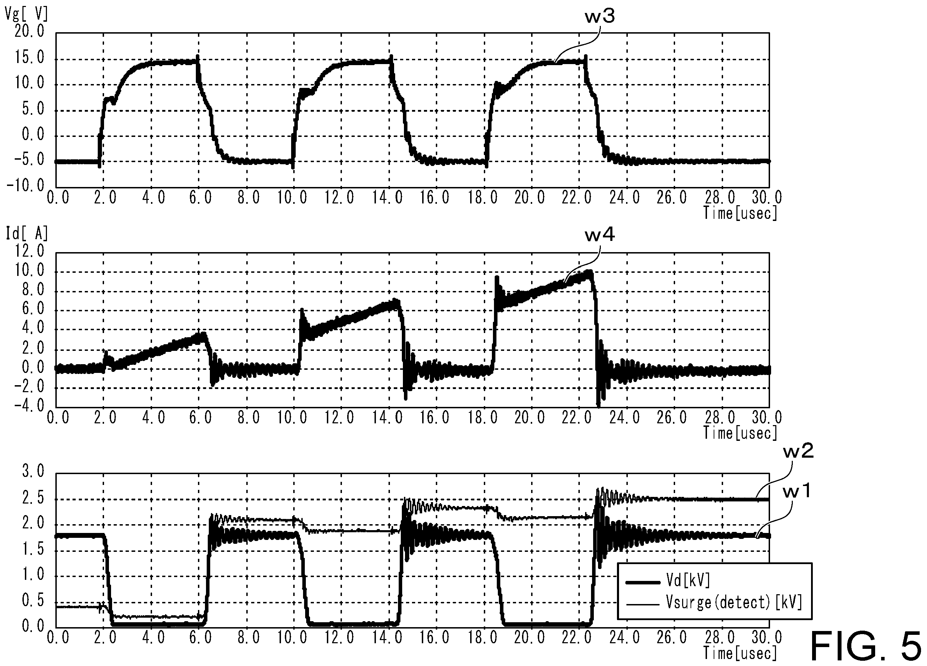

FIG. 4 illustrates the result of the simulation, whereas FIG. 5 illustrates voltage waveform diagrams of the voltage input node IN and the voltage output node OUT based on experimental results. FIG. 5 also illustrates a gate voltage Vg waveform w3 and a drain current Id waveform w4 of a power transistor in a main circuit (for example, a power converter) that supplies a voltage to the voltage input node IN in the peak hold circuit 1. As illustrated in FIG. 5, the voltage of the voltage input node IN changes in synchronization with changes in the gate voltage Vg and drain current Id of a switching transistor in the main circuit, and a surge voltage and ringing occur when the voltage changes. The voltage level of the voltage waveform w1 of the voltage input node IN in FIG. 5 is also scaled and displayed.

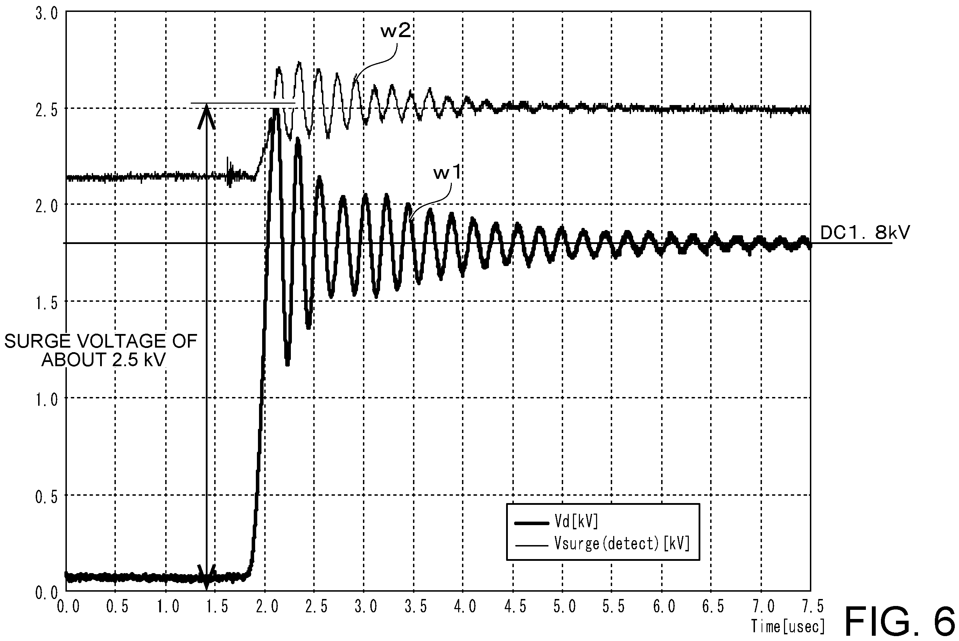

FIG. 6 is an enlarged diagram of voltage waveforms of the voltage input node IN and the voltage output node OUT illustrated in FIG. 5. FIG. 6 illustrates an example in which, when a DC voltage of 1.8 kV is input to the voltage input node IN, a surge voltage of 2.5 kV is generated at the rise of the voltage. Further, ringing occurs for a while after the voltage rises. As illustrated in FIG. 6, in the peak hold circuit 1 of FIG. 1, when the surge voltage is generated in the voltage of the voltage input node IN, the peak value of the surge voltage is held and output from the voltage output node OUT. Even when the voltage of the voltage input node IN varies due to ringing, the voltage of the voltage output node OUT has a stable voltage level without being affected by ringing after a while from a voltage change point.

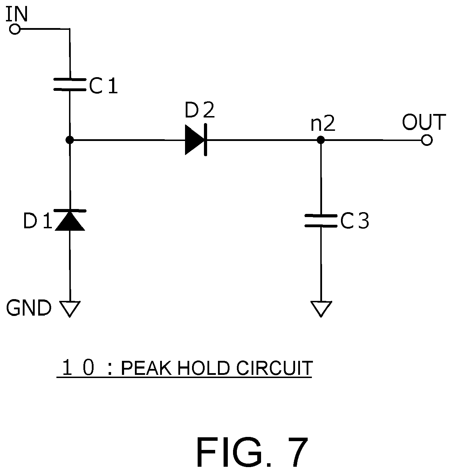

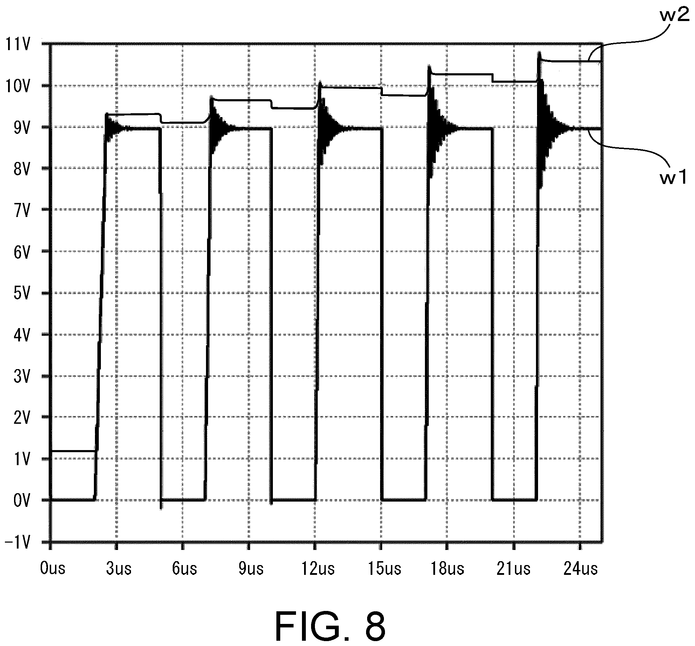

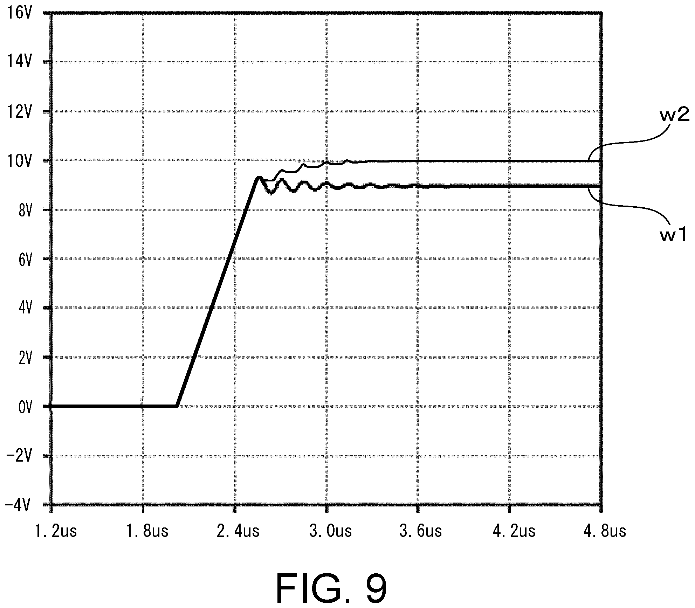

FIG. 7 is a circuit diagram of a peak hold circuit 10 according to a comparative example. The peak hold circuit 10 illustrated in FIG. 7 has a configuration in which the second capacitor C2 is omitted from the peak hold circuit 1 illustrated in FIG. 1. FIG. 8 illustrates voltage waveform diagrams of a voltage input node IN and a voltage output node OUT in the peak hold circuit 10 of FIG. 7. FIG. 9 is an enlarged diagram of a part of the voltage waveforms illustrated in FIG. 7.

In the peak hold circuit 10 of FIG. 7, when the voltage of the voltage input node IN increases, the current having flown from the voltage input node IN to the first capacitor C1 flows through the second rectifying element D2 to the third capacitor C3. The electric charge stored in the third capacitor C3 cannot be discharged to a side of the voltage input node IN because of the second rectifying element D2. For this reason, as illustrated in FIG. 8, when the voltage of the voltage input node IN changes periodically, the voltage across the third capacitor C3 gradually increases every cycle. Consequently, it is impossible to hold only the surge voltage included in the voltage of the voltage input node IN and output the surge voltage from the voltage output node OUT. Therefore, the peak hold circuit 10 illustrated in FIG. 7 cannot accurately detect the surge voltage.

As illustrated in the enlarged diagram of FIG. 9, when the voltage of the voltage input node IN varies due to ringing, the electric charge stored in the third capacitor C3 increases and the voltage of the voltage output node OUT becomes higher. For this reason, a difference occurs in the voltage level of the voltage output node OUT between a case where the voltage of the voltage input node IN varies due to ringing and a case where the voltage of the voltage input node IN does not vary due to ringing.

As compared with the peak hold circuit 10 according to a comparative example illustrated in FIG. 7, when the voltage of the voltage input node IN increases in the peak hold circuit 1 according to the present example, the current having flown from the voltage input node IN to the first capacitor C1 flows to the second capacitor C2. For this reason, the electric charge based on a surge voltage can be stored in the second capacitor C2. If the voltage across the second capacitor C2 becomes too high, the electric charge is stored in the third capacitor C3 through the second rectifying element D2. When the voltage of the voltage input node IN becomes low, the electric charge stored in the second capacitor C2 is discharged through the first capacitor C1 and the voltage input node IN, but the electric charge stored in the third capacitor C3 is not discharged because of the second rectifying element D2. Thereafter, when the voltage of the voltage input node IN increases, electric charge is stored again in the second capacitor C2. Consequently, the third capacitor C3 continues to hold the electric charge based on the surge voltage of the voltage input node IN, and there is no possibility that the voltage of the voltage output node OUT increases stepwise.

Further, even when the voltage of the voltage input node IN varies due to ringing, the capacitances of the first to third capacitors C1 to C3 are set so as to satisfy expression (4) described above, so that the voltage of the voltage output node OUT is not affected by ringing.

As described above, although the peak hold circuit 1 illustrated in FIG. 1 is a simple circuit in which the second capacitor C2 is added to the peak hold circuit 10 according to a comparative example illustrated in FIG. 7, the peak hold circuit 1 can accurately hold a peak value of the surge voltage input to the voltage input node IN and output the peak value of the surge voltage from the voltage output node OUT. According to the present example, even if the voltage input to the voltage input node IN changes periodically, there is no possibility that the voltage of the voltage output node OUT increases stepwise. Further, even when the voltage of the voltage input node IN varies due to ringing, the capacitances of the first to third capacitors C1 to C3 can be optimized so that the voltage of the voltage output node OUT is not affected by ringing.

As described above, the peak hold circuit 1 illustrated in FIG. 1 can accurately hold and output the surge voltage of the voltage input node IN. It is thus possible to provide a margin for a timing of AD conversion of an output voltage of the peak hold circuit 1. That is, even when the pulse width of the voltage of the voltage input node IN varies due to PWM control, the output voltage of the peak hold circuit 1 can be AD-converted with a margin.

(Second Example)

In a second example, a forward voltage of a first rectifying element D1 is compensated by a voltage of a voltage output node OUT.

As indicated by expression (2) and expression (3) described above, the voltage of the voltage output node OUT becomes lower by the forward voltage of the first rectifying element D1. This is because a cathode of the first rectifying element D1 is connected to a connection node n1 of a first capacitor C1 and a second capacitor C2. When a voltage of a voltage input node IN decreases, electric charge stored in the first capacitor C1 is discharged, and thus the voltage of the connection node n1 of the first capacitor C1 and the second capacitor C2 decreases to a negative voltage. More specifically, the voltage of the connection node n1 is lower than a voltage of a reference voltage node GND (hereinafter, referred to as "ground voltage") by the forward voltage of the first rectifying element D1. For this reason, even when the voltage of the voltage input node IN increases thereafter, the voltage of the voltage output node OUT becomes lower by the forward voltage of the first rectifying element D1.

If control is executed so that the voltage of the connection node n1 of the first capacitor C1 and the second capacitor C2 becomes the ground voltage when the voltage of the voltage input node IN decreases, a voltage drop corresponding to the forward voltage of the first rectifying element D1 in expression (2) and expression (3) described above can be compensated.

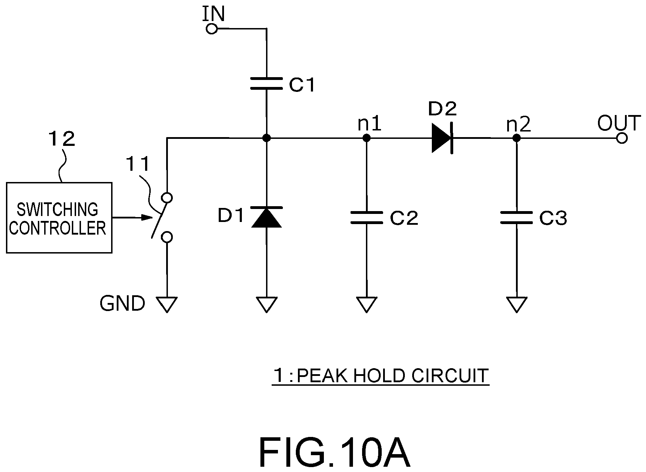

FIG. 10A is a circuit diagram illustrating a first example of compensating for a voltage drop corresponding to a forward voltage of the first rectifying element D1. A peak hold circuit 1 illustrated in FIG. 10A includes a switch 11 that is connected in parallel between an anode and a cathode of the first rectifying element D1, and a switching controller 12 that controls the switch 11. The switch 11 is turned on at a timing when the voltage of the voltage input node IN starts to decrease, and is turned off before the voltage of the voltage input node IN starts to increase. When the switch 11 is turned on, the voltage of the connection node n1 connected to the cathode of the first rectifying element D1 is forcibly set to the ground voltage. Consequently, the voltage drop corresponding to the forward voltage of the first rectifying element D1 can be compensated, and the term -VfDl on the right hand side of expression (2) and expression (3) can be eliminated.

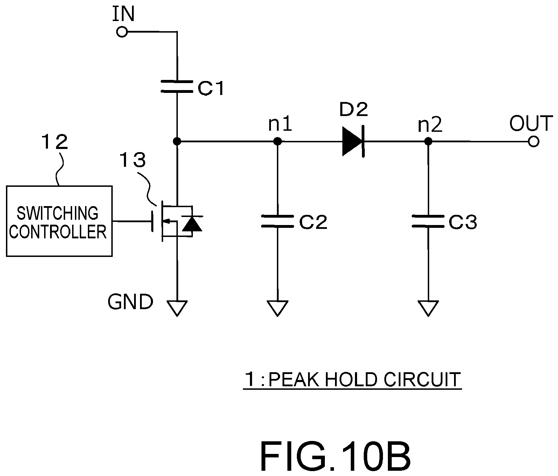

FIG. 10B is a circuit diagram illustrating a second example of compensating for the voltage drop corresponding to the forward voltage of the first rectifying element D1. In FIG. 10B, an N-type MOS transistor 13 is used instead of the first rectifying element D1 and the switch 11 of FIG. 10A. The N-type MOS transistor 13 incorporates a body diode. By controlling a gate voltage using this body diode as the first rectifying element D1, a drain voltage of the N-type MOS transistor 13 can be set to the ground voltage at the timing when the voltage of the voltage input node IN starts to decrease.

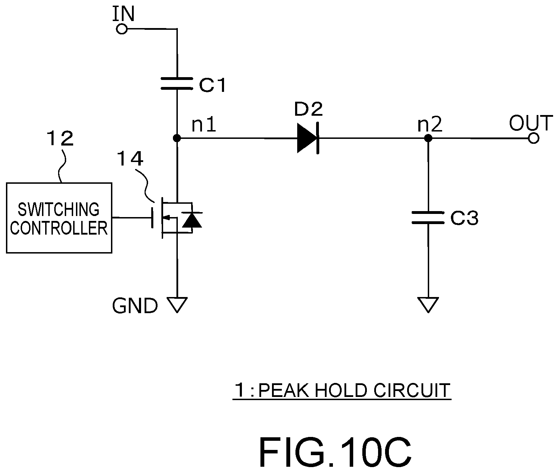

FIG. 10C is a circuit diagram illustrating a third example of compensating for the voltage drop corresponding to the forward voltage of the first rectifying element D1. A peak hold circuit 1 illustrated in FIG. 10C includes an N-type MOS transistor 14, and uses not only a body diode but also a parasitic capacitance of the N-type MOS transistor 14 instead of the second capacitor C2. In a case of FIG. 10C, the second rectifying element D2 and the second capacitor C2 illustrated in FIG. 1 can be omitted.

As described above, in the second example, when the voltage of the voltage input node IN decreases, to compensate for the voltage of the connection node n1 of the first capacitor C1 and the second capacitor C2 becoming lower than the ground voltage by the forward voltage of the first rectifying element D1, the voltage of the connection node n1 is forcibly set to the ground voltage in synchronization with the timing when the voltage of the voltage input node IN decreases. As a result, the problem that the voltage of the voltage output node OUT decreases by the forward voltage of the first rectifying element D1 does not occur, and a peak value of the surge voltage input to the voltage input node IN can be held accurately at the voltage output node OUT.

(Third Example)

In a third example, when the voltage of a voltage input node IN decreases, the voltage of a voltage output node OUT is prevented from being temporarily decreased due to the voltage of the voltage input node IN.
FIG. 11 is a circuit diagram of a peak hold circuit 1 according to the third example. The peak hold circuit 1 of FIG. 11 includes a third rectifying element D3 and a fourth capacitor C4 in addition to the configuration of FIG. 1. An anode of the third rectifying element D3 is connected to a connection node n2 of a cathode of a second rectifying element D2 and a third capacitor C3. The fourth capacitor C4 is connected between a cathode of the third rectifying element D3 and a reference voltage node GND.
A peak value of a voltage input to the voltage input node IN is output from the cathode of the third rectifying element D3. In FIG. 11, the voltage output node OUT is connected to the cathode of the third rectifying element D3, but it is not always necessary to connect the voltage output node OUT to the cathode of the third rectifying element D3. For example, the cathode of the third rectifying element D3 may be connected to an anode of another rectifying element, and a cathode of another rectifying element may be connected to a capacitor different from the first to fourth capacitors C1 to C4 and the voltage output node OUT.
In the peak hold circuit 1 of FIG. 11, as the third rectifying element D3 and the fourth capacitor C4 are connected to a side of an output stage of the second rectifying element D2 and the third capacitor C3, the influence of the parasitic capacitance can be reduced as compared with the peak hold circuit 1 of FIG. 1. Even if the voltage of the voltage input node IN decreases, the voltage of the voltage output node OUT does not decrease and a peak value of a surge voltage can be stably held.

(Fourth Example)

In a fourth example, a voltage drop at a voltage output node OUT is compensated by a differential amplifier.

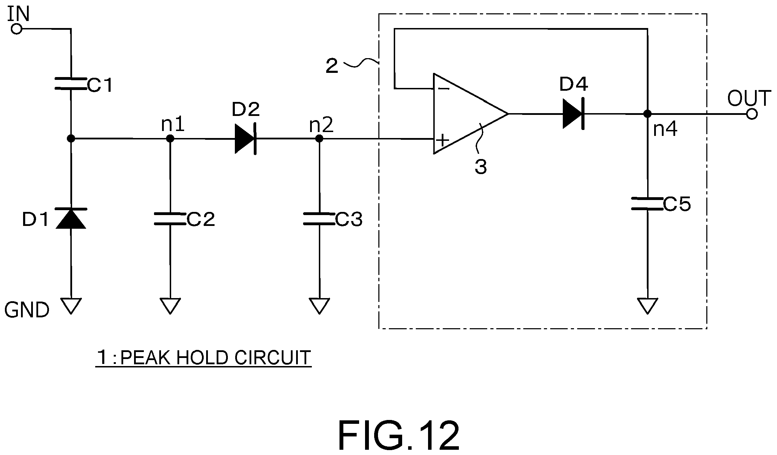

FIG. 12 is a circuit diagram of a peak hold circuit 1 according to the fourth example. The peak hold circuit 1 illustrated in FIG. 12 includes a voltage compensation circuit 2 that is connected between a cathode of a second rectifying element D2 and a voltage output node OUT.
The voltage compensation circuit 2 includes a differential amplifier 3, a fourth rectifying element D4, and a fifth capacitor C5. The differential amplifier 3 outputs a voltage corresponding to a difference voltage between a cathode voltage of the second rectifying element D2 and a feedback voltage. The differential amplifier 3 can be configured by an operational amplifier IC or the like. The fourth rectifying element D4 has an anode connected to an output node of the differential amplifier 3. The fifth capacitor C5 is connected between a cathode of the fourth rectifying element D4 and a reference voltage node GND. The feedback voltage corresponding to electric charge stored in the fifth capacitor C5 is input to the differential amplifier 3.
The voltage compensation circuit 2 can extend a period during which voltage compensation is performed even if a period during which a voltage of a voltage input node IN changes is short. A low-speed operational amplifier can thus be used as the differential amplifier 3.

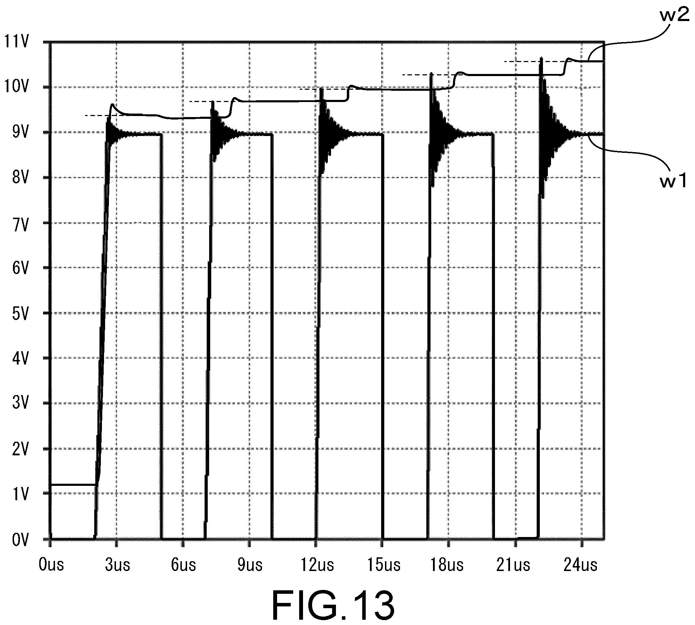

FIG. 13 illustrates voltage waveform diagrams of the voltage input node IN and the voltage output node OUT in the peak hold circuit 1 of FIG. 12. By executing feedback control on the voltage of the voltage output node OUT using the differential amplifier 3, even if the voltage of the voltage input node IN decreases periodically, there is no possibility that the voltage of the voltage output node OUT decreases accordingly. Consequently, the peak hold circuit 1 illustrated in FIG. 12 can continuously hold a peak value of the surge voltage of the voltage input node IN stably.
As described above, in the fourth example, the voltage compensation circuit 2 is connected to a cathode side of the second rectifying element D2, and feedback control is executed so as to maintain a holding voltage of the voltage output node OUT. Consequently, even if the voltage of the voltage input node IN decreases periodically, it is possible to prevent a problem that the voltage of the voltage output node OUT decreases due to the voltage of the voltage input node IN.

(Fifth Example)

A fifth example relates to a power converter that incorporates the peak hold circuit 1 according to any of the first to fourth examples.

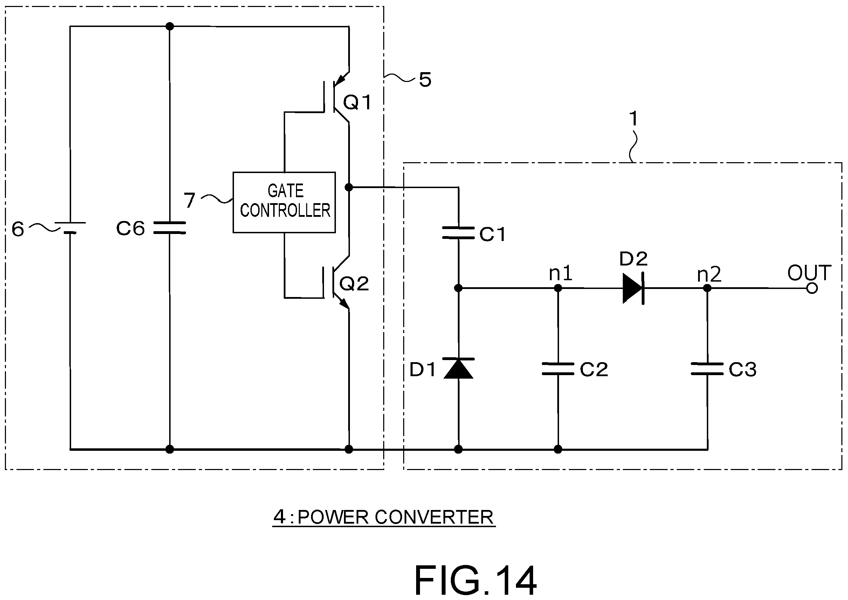

FIG. 14 is a circuit diagram of a first example of a power converter 4. The power converter 4 illustrated in FIG. 14 includes a power conversion circuit 5 that performs power conversion and the peak hold circuit 1 according to any of the first to fourth examples.

The power conversion circuit 5 performs an operation of converting a DC voltage into an AC voltage. The power conversion circuit 5 includes a DC power supply 6, a capacitor C6, a high-side transistor Q1, a low-side transistor Q2, and a gate controller 7 that controls gate voltages of these transistors Q1 and Q2.

The power conversion circuit 5 converts the DC voltage into the AC voltage by alternately turning on and off the high-side transistor Q1 and the low-side transistor Q2. In some cases, a large surge voltage is generated when these transistors are switched. Depending on the magnitude of the surge voltage, a motor or the like using the AC voltage generated by the power conversion circuit 5 may be broken or EMI noise may occur. Consequently, the peak hold circuit 1 illustrated in FIG. 14 performs an operation of holding a peak value of the surge voltage. The peak value of the surge voltage held by the peak hold circuit 1 may be digitized and then sequentially stored in a storage unit (not illustrated) or the like so that the peak value of the surge voltage can be analyzed later.

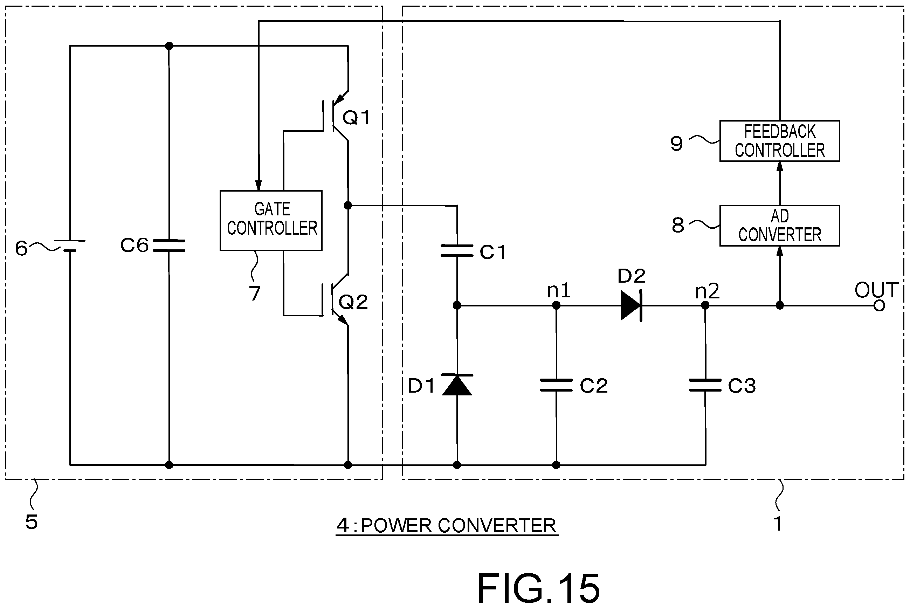

FIG. 15 is a circuit diagram of a second example of the power converter 4. A power converter 4 illustrated in FIG. 15 includes an AD converter 8 and a feedback controller 9 in addition to the configuration in FIG. 14.

The AD converter 8 converts an output voltage of the peak hold circuit 1 into a digital signal. The feedback controller 9 generates a gate control signal for reducing a surge voltage based on the digital signal converted by the AD converter 8. The gate control signal output from the feedback controller 9 is input to the gate controller 7. The gate controller 7 controls gate voltages of the high-side transistor Q1 and the low-side transistor Q2 so that the surge voltage is reduced based on the gate control signal.

FIG. 14 and FIG. 15 are merely examples of devices that use the peak hold circuits 1 according to the first to fourth examples. The peak hold circuits 1 according to the first to fourth examples can be incorporated in or connected to various devices that may output a surge voltage.

As described above, as the peak hold circuit 1 according to any of the first to fourth examples is incorporated in or connected to various devices that may output a surge voltage in the fifth example, the surge voltage output from such devices can be accurately held and output. Therefore, it is possible to perform a maintenance check to check whether the surge voltage is within a normal range, and to execute feedback control on devices according to the magnitude of the surge voltage.

While certain examples have been described, these examples have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1. A peak hold circuit comprising:

   a first capacitor (C1) and a second capacitor (C2) that are serially connected between a voltage input node and a reference voltage node;
   a first rectifying element (D1) that has an anode connected to the reference voltage node and a cathode connected to a connection node of the first capacitor (C1) and the second capacitor (C2);
   a second rectifying element (D2) that has an anode connected to the connection node of the first capacitor (C1) and the second capacitor (C2), and a cathode; and
   a third capacitor (C3) that is connected between the cathode of the second rectifying element (D2) and the reference voltage node,
   wherein a peak value of a surge voltage input to the voltage input node is output from the cathode of the second rectifying element (D2).

2. The peak hold circuit according to claim 1,
   wherein a capacitance of the second capacitor (C2) is larger than a capacitance of the third capacitor (C3).

3. The peak hold circuit according to claim 1,
   wherein a capacitance of the second capacitor (C2) is larger than a capacitance of the first capacitor (C1).

4. The peak hold circuit according to claim 2,

wherein capacitances of the first to third capacitors (CI-C3) are set so as to satisfy expression (1), where the capacitance of the first capacitor (C1) is denoted by $C_1$, the capacitance of the second capacitor (C2) is denoted by $C_2$, the capacitance of the third capacitor (C3) is denoted by $C_3$, and a forward voltage of the first to second rectifying elements (D2) is denoted by Vf.

$$C_3 \leq \frac{(C_2{}^2 + 2C_1C_2 + C_1{}^2)Vf}{C_1 Vin + (-C_2 - C_1)Vf} \quad \cdots (1)$$

5. The peak hold circuit according to claim 1 further comprising:
a switch (11) that switches whether the connection node of the first capacitor (C1) and the second capacitor (C2) and the reference voltage node are short-circuited.

6. The peak hold circuit according to claim 5,
wherein the switch (11) is turned on or off in synchronization with a timing when a voltage level of the voltage input node changes.

7. The peak hold circuit according to claim 1 further comprising:
a transistor (13) that incorporates the first rectifying element (D1) and controls a gate voltage to switch whether a connection node of the first capacitor (C1) and the second capacitor (C2) and the reference voltage node are short-circuited.

8. The peak hold circuit according to claim 7,
wherein the transistor (13) is turned on or off in synchronization with a timing when a voltage level of the voltage input node changes.

9. The peak hold circuit according to claim 7,
wherein the first rectifying element (D1) is a body diode of the transistor (13).

10. The peak hold circuit according to claim 7,
wherein the second capacitor (C2) is a parasitic capacitance of the transistor (13).

11. The peak hold circuit according to claim 1, further comprising:

a third rectifying element (D3) that has an anode connected to a connection node connecting a cathode of the second rectifying element (D2) and the third capacitor (C3); and
a fourth capacitor (C4) that is connected between a cathode of the third rectifying element (D3) and the reference voltage node,
wherein a peak value of a surge voltage input to the voltage input node is output from the cathode of the third rectifying element (D3).

12. The peak hold circuit according to claim 1, further comprising:

a voltage compensation circuit (2) that holds a cathode voltage of the second rectifying element (D2),
wherein the voltage compensation circuit (2) comprises
a differential amplifier (3) that outputs a voltage corresponding to a difference voltage between the cathode voltage of the second rectifying element (D2) and a feedback voltage,
a fourth rectifying element (D4) that has an anode connected to an output node of the differential amplifier (3), and
a fifth capacitor (C5) that is connected between a cathode of the fourth rectifying element (D4) and the reference voltage node, and
wherein the feedback voltage corresponding to electric charge stored in the fifth capacitor (C5) is input to the differential amplifier (3).

13. A power converter comprising:

a power conversion circuit that performs power conversion; and
a peak hold circuit that holds a surge voltage included in an output voltage of the power conversion circuit,

wherein the peak hold circuit comprises

a first capacitor (C1) and a second capacitor (C2) that are serially connected between a voltage input node to which the output voltage of the power conversion circuit is input and a reference voltage node,

a first rectifying element (D1) that has an anode connected to the reference voltage node and a cathode connected to a connection node of the first capacitor (C1) and the second capacitor (C2),

a second rectifying element (D2) that has an anode connected to the connection node of the first capacitor (C1) and the second capacitor (C2), and a cathode, and

a third capacitor (C3) that is connected between the cathode of the second rectifying element (D2) and the reference voltage node, and

wherein a peak value of a surge voltage input to the voltage input node is output from the cathode of the second rectifying element (D2).

**14.** The power converter according to claim 13,
wherein a capacitance of the second capacitor (C2) is larger than a capacitance of the third capacitor (C3).

**15.** The power converter according to claim 13,
wherein a capacitance of the second capacitor (C2) is larger than a capacitance of the first capacitor (C1).

1 : PEAK HOLD CIRCUIT

# FIG. 1

FIG. 2A

FIG. 2B

IN

y3

C1

D1

GND

n1

C2

D2

n2

C3

OUT

# FIG. 2C

FIG. 3

EP 3 742 594 A1

FIG. 4

FIG. 5

EP 3 742 594 A1

FIG. 6

EP 3 742 594 A1

1 0 : PEAK HOLD CIRCUIT

FIG. 7

FIG. 8

FIG. 9

EP 3 742 594 A1

1 : PEAK HOLD CIRCUIT

# FIG.10A

1:PEAK HOLD CIRCUIT

# FIG.10B

1 : PEAK HOLD CIRCUIT

# FIG.10C

IN

C1

D2     D3

n1       n2       n3     OUT

D1

GND

C2     C3     C4

1 : PEAK HOLD CIRCUIT

# FIG.11

## FIG.12

FIG.13

EP 3 742 594 A1

FIG.14

4 : POWER CONVERTER

FIG.15

Europäisches
Patentamt

European
Patent Office

Office européen
des brevets

# EUROPEAN SEARCH REPORT

Application Number

EP 20 16 1882

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | M. S. Naldu ET AL: "7 Measurement of High Voltages and Currents" In: "High Voltage Engineering", 31 December 2013 (2013-12-31), XP055725438, * figure 7.17c * | 1-15 | INV. H02M1/32 H03K17/082 |
| X | "Peak Voltmeters with Potential Dividers", Chapter: High Voltage Engineering - Measurement of High Voltage and High Currents¦ Study Material, Lecturing Notes, Assignment, Reference, Wiki description explanation, brief detail ¦ , 3 May 2017 (2017-05-03), XP055725455, Retrieved from the Internet: URL:http://www.brainkart.com/article/Peak-Voltmeters-with-Potential-Dividers_12914/ [retrieved on 2020-08-26] * "Hence Cs should be small as compared with C2 to keep down the recharge error."; figures 4, 5 * | 1-15 | |
| A | E Kuffel ET AL: "Measurement of high voltages" In: "High Voltage Engineering", 31 December 2000 (2000-12-31), Newnes, XP055725389, ISBN: 978-0-7506-3634-6 pages 77-129, * "Hence Cs should be small as compared with C2."; page 114 * | 1-15 | TECHNICAL FIELDS SEARCHED (IPC) H02M H03K |
| A | US 2012/268146 A1 (NAGAO MASARU [JP]) 25 October 2012 (2012-10-25) * paragraphs [0032] - [0036]; figures 3, 4 * | 5-10 | |

-/--

The present search report has been drawn up for all claims

| Place of search | Date of completion of the search | Examiner |
|---|---|---|
| The Hague | 26 August 2020 | Zeljkovic, Sandra |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

Europäisches
Patentamt

European
Patent Office

Office européen
des brevets

**EUROPEAN SEARCH REPORT**

Application Number

EP 20 16 1882

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/375423 A1 (IKEDA KENTARO [JP]) 27 December 2018 (2018-12-27) * figures 1,2, 5, 7, 8 * | 5-10 | |
| A | US 2011/235374 A1 (MYERS PETER J [US] ET AL) 29 September 2011 (2011-09-29) * figure 2 * | 1-15 | |
| A | Tony R. Kuphaldt: "Chapter 2: Diodes and Rectifiers" In: "Lessons In Electric Circuits, Volume III - Semiconductors, 5th edition", 2 July 2007 (2007-07-02), Open Book Project, GB, XP055513681, pages 25-99, * figure 2.48 * | 1-15 | |

TECHNICAL FIELDS
SEARCHED      (IPC)

The present search report has been drawn up for all claims

| Place of search | Date of completion of the search | Examiner |
|---|---|---|
| The Hague | 26 August 2020 | Zeljkovic, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 16 1882

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2020

| Patent document cited in search report | | Publication date | Patent family member(s) | | Publication date |
|---|---|---|---|---|---|
| US 2012268146 | A1 | 25-10-2012 | CN | 102725643 A | 10-10-2012 |
| | | | JP | WO2011086685 A1 | 16-05-2013 |
| | | | US | 2012268146 A1 | 25-10-2012 |
| | | | WO | 2011086685 A1 | 21-07-2011 |
| US 2018375423 | A1 | 27-12-2018 | CN | 109119973 A | 01-01-2019 |
| | | | JP | 2019009914 A | 17-01-2019 |
| | | | US | 2018375423 A1 | 27-12-2018 |
| US 2011235374 | A1 | 29-09-2011 | CN | 102906956 A | 30-01-2013 |
| | | | EP | 2553787 A1 | 06-02-2013 |
| | | | KR | 20130010478 A | 28-01-2013 |
| | | | US | 2011235374 A1 | 29-09-2011 |
| | | | WO | 2011119700 A1 | 29-09-2011 |

EPO FORM P0459

For more details about this annex : see Official Journal of the European Patent Office, No. 12/82